# EUROPEAN PATENT SPECIFICATION

(11) **EP 3 565 008 B1**
(45) Date of publication and mention of the grant of the patent: **24.02.2021**
(21) Application number: 17887574.6
(22) Date of filing: 14.03.2017
(51) Int. Cl.: H01L 31/18, H01L 21/308, H01L 21/306, H01L 21/67, H01L 31/068

(54) **WATER FILM SOLUTION FOR ETCHING SILICON WAFER OF SOLAR CELL AND USE THEREOF**
WASSERFILMLÖSUNG ZUM ÄTZEN EINES SILICIUMWAFERS EINER SOLARZELLE UND VERWENDUNG DAVON
SOLUTION DE FILM D'EAU POUR GRAVER UNE TRANCHE DE SILICIUM DE CELLULE SOLAIRE ET SON UTILISATION

(30) Priority: 30.12.2016 CN 201611257627
(43) Date of publication of application: 06.11.2019
(73) Proprietor: EGing Photovoltaic Technology Co., Ltd, Changzhou, Jiangsu 213213 (CN)
(72) Inventor: SUN, Tietun, Changzhou, Jiangsu 213213 (CN); ZHANG, Kaisheng, Changzhou, Jiangsu 213213 (CN); WU, Jiahong, Changzhou, Jiangsu 213213 (CN)
(74) Representative: Algemeen Octrooi- en Merkenbureau B.V.
(86) International application number: PCT/CN2017/076574
(87) International publication number: WO 2018/120433

(56) References cited:
- CN-A- 102 019 280
- CN-A- 102 214 732
- CN-A- 103 258 728
- CN-A- 103 618 020
- CN-A- 105 932 113
- CN-A- 105 932 113
- US-A1- 2003 079 764
- US-A1- 2012 234 793
- US-A1- 2016 329 451
- SATOSHI TAKEI ET AL: "Electron Beam Lithography Using Highly Sensitive Negative Type of Plant-Based Resist Material Derived from Biomass on Hardmask Layer", APPLIED PHYSICS EXPRESS, vol. 4, no. 10, 5 October 2011 (2011-10-05), pages 106502-1-106502-3, XP055699845, JP ISSN: 1882-0778, DOI: 10.1143/APEX.4.106502

## Description

### TECHNICAL FIELD

The present invention belongs to the technical field of solar cells, and in particular relates to a water film solution used during etching a silicon wafer of a solar cell and a use thereof.

### BACKGROUND

A general method for manufacturing a silicon solar cell is: firstly performing a texturing process on a P-type or N-type silicon wafer with a clean surface to form a textured-surface structure; secondly, performing diffusion and sintering on the surface of the silicon wafer to form an N+ or P+ emitter; removing the diffusion layer on the side surface and the back surface of the silicon wafer by a wet etching method; then forming a layer of SiN film with anti-reflection function on the front surface; and finally, forming a metal electrode respectively on the front surface and the back surface of the silicon wafer; and forming a crystalline silicon solar cell through a sintering process.

Before the wet etching, it is generally required to use a water film protection method to spray a water film on the front surface of the silicon wafer before the silicon wafer is put into the etching bath, thereby preventing the liquid medicine from spilling on the front surface of the silicon wafer to cause excessive etching and cause damage to the PN junction of the diffusion surface. However, the problem is that when etching or polishing with a mixed acid, high-concentration acid (such as HF, nitric acid, etc.) in the etching bath is easily volatilized, and as the amount of volatilization increases, the volatilized acid is redissolved in the water film, causing vapor phase corrosion on the surface of the cell and damage to the PN junction on the surface. Second, in order to remove the textured surface on the back surface of the silicon wafer to form a polished structure on the back surface, a large amount of etching is required (generally when the etching amount on the back surface of the silicon wafer is 6 µm or more), which further increases the corrosion and damage to the PN junction. Therefore, pure water film cannot desirably protect the front PN junction.

Chinese patent publication no. CN 105932113 describes a wet etching method of a silicon solar cell implementing water film protecting step of forming a water film protecting layer on a diffusion surface of a silicon wafer by using a water film solution, wherein the water film protecting layer always exists until etching of the silicon is finished, and with the concentration of H+ ions in the water film solution being greater than 10-7 mol/L, and with the viscosity of the water film solution being greater than that of water under equal conditions.

### SUMMARY

The present invention is directed to the above technical problem, and provides a water film solution used during etching a solar cell silicon wafer, wherein the water film solution is formed by dispersing glucose and bisfluorosulfonimide salt in water and is specified in claim 1.

The glucose is contained in the water film solution in an amount of 1.5 to 4.0 g/L.

The bisfluorosulfonimide salt is sodium bisfluorosulfonimide or lithium bisfluorosulfonimide, and is contained in the water film solution in an amount of 0.1 to 0.35 mol/L.

During the preparation process, the water film solution can be obtained by adding the components to deionized water and stirring the same to be even.

The present invention also provides a method using the water film solution described above as specified in claim 2, describing the steps of:
(1) using the water film solution to form a protective layer on a diffusion front surface of a silicon wafer,
   for example, the water film is sprayed on the diffusion surface by a water film spray coating technique, and the water film is adsorbed on the surface by utilizing the hydrophilicity of silica; and
(2) introducing the silicon wafer processed in the step (1) into etching bath to etch a PN junction on a back surface and an edge of the silicon wafer.

In the etching bath, the silicon wafer is etched by floating on the etching liquid, or by using a liquid roller to bring the etching liquid to the back surface of the silicon wafer.

The present invention has the beneficial effects in that in the present invention, by adding both of glucose and a difluorosulfonimide salt in a water film solution, it is found that it can suppress the re-dissolution, of the volatilized acid in the etching solution, in the water film, thereby reducing the damage to the PSG and PN junction on the diffusion surface (front surface). Moreover, the water film solution itself has no damage to the diffusion surface and the silicon wafer substrate, and glucose as a natural green additive does not have any pollution itself.

In addition, the viscosity of the water film containing the additive is slightly larger than the viscosity of the pure water under the same conditions, and the increase of the viscosity can promote the corresponding increase of the surface tension at the edge of the silicon wafer, and can avoid the overetching to some extent during etching.

Since the etching amount of the acid etching in the related art can only reach 4 to 5 micrometers, increasing the concentration of the etching solution or increasing the etching time may cause vapor phase corrosion on the surface of the cell, destroying the PN junction on the surface. With the etching amount of 4 to 5 micrometers, it is difficult to completely remove the textured surface to form a polished structure for some silicon wafers having a textured-surface structure on the back surface, especially for PERC (Passivated Emitter and Rear Cell). It may cause the polished surface to be uneven, affect the reflectivity of long-wavelength lights, and also increase the backside recombination. In the present invention, using a special water film, the etching amount on the back surface of the silicon wafer is greater than or equal to 7 micrometers, so that the water film can desirably protect the front PN junction.

### DETAILED DESCRIPTION

All operations in the following embodiment and comparative examples are carried out at room temperature (25 °C):

### Embodiment 1

A water film solution having a glucose content of 2.0 g/L and a sodium bisfluorosulfonimide content of 0.25 mol/L is prepared.
(1) The water film is sprayed on a diffusion front surface formed by diffusion and sintering on a surface of a silicon wafer, to form a flat water film protective layer by a water film spray coating technique, wherein the water film protective layer remains until the step of etching the silicon wafer is completed.
(2) The silicon wafer processed through the step (1) is introduced into etching bath, and the etching liquid is a common mixed acid of HF/HNO₃/H₂SO₄. In the etching bath, the silicon wafer is etched by floating on the etching liquid.

The etching amount on the back surface of the silicon wafer is 8 µm.

### Comparative Example 1

Pure water is used in place of the water film in Embodiment 1, and the rest of the operation is the same as in Embodiment 1, except that the etching amount on the back surface of the silicon wafer is controlled to 5 µm. Compared to Embodiment 1, the textured surface cannot be completely removed to form a polished structure, and the polished surface is not flat and even.

### Comparative Example 2

Pure water is used in place of the water film in Embodiment 1, and the rest of the operation is the same as in Embodiment 1, and the etching amount on the back surface of the silicon wafer is also 8 µm.

### Comparative Example 3

A water film solution having a glucose content of 2.0 g/L is prepared, and in order to make the viscosity of the water film at the same level as in Embodiment 1 and thus to avoid the error in comparison, sodium chloride is used in the present operation in place of the sodium bisfluorosulfonimide in Embodiment 1, to be added to the water film solution.

The water film described above is used in place of the water film in Embodiment 1, and the rest of the operation is the same as in Embodiment 1, and the etching amount on the back surface of the silicon wafer is also 8 µm.

### Comparative Example 4

A water film solution having a sodium bisfluorosulfonimide content of 0.25 mol/L is prepared, and in order to make the viscosity of the water film at the same level as in Embodiment 1 and thus to avoid the error in comparison, sodium chloride is used in the present operation in place of glucose in Embodiment 1, to be added to the water film solution.

The water film described above is used in place of the water film of Embodiment 1, and the rest of the operation is the same as in Embodiment 1, and the etching amount on the back surface of the silicon wafer is also 8 µm.

The silicon wafers obtained in the above embodiment and comparative examples are fabricated into cell sheets according to the same related art, and then the respective electrical properties are examined. The results are as follows.

| | Uoc (mV) | Isc (A) | EFF (%) |
|---|---|---|---|
| Embodiment 1 | 652.3 | 9.605 | 20.32 |
| Comparative Example 1 | 632.8 | 9.113 | 18.73 |
| Comparative Example 2 | 563.2 | 7.862 | 12.35 |
| Comparative Example 3 | 572.8 | 8.114 | 13.22 |
| Comparative Example 4 | 563.5 | 7.858 | 12.35 |

## Claims

1. A water film solution for use during etching a solar cell silicon wafer, **characterized in that** the water film solution comprises glucose and bisfluorosulfonimide salt dispersed in water, wherein the glucose is contained in the water film solution in an amount of 1.5 to 4.0 g/L and wherein the bisfluorosulfonimide salt is sodium bisfluorosulfonimide or lithium bisfluorosulfonimide, and is contained in the water film solution in an amount of 0.1 to 0.35 mol/L.

2. A method using the water film solution according to claim 1, **characterized by** comprising the steps of:
a step 1 of using the water film solution to form a protective layer on a diffusion front surface of a silicon wafer; and
a step 2 of introducing the back surface and an edge of the silicon wafer processed in the step 1 into an etching bath to etch a PN junction located on the back surface and the edge of the silicon wafer.

3. The method using the water film solution according to claim 2, wherein in the step 1, the water film is sprayed on the diffusion front surface by a water film spray coating technique to form the protective layer.

4. The method using the water film solution according to claim 2, wherein in the step 2, in the etching bath, the back surface and the edge of the silicon wafer are etched by floating on an etching liquid.

5. The method fusing the water film solution according to claim 2, wherein in the step 2, in the etching bath, the back surface and the edge of the silicon wafer are etched by using a liquid roller to bring an etching liquid to the back surface of the silicon wafer.

## Patentansprüche

1. Wasserfilmlösung zur Verwendung während einer Ätzung eines Solarzellensiliciumwafers, **dadurch gekennzeichnet, dass** die Wasserfilmlösung Glukose und Bisfluorsulfonimidsalz, das in Wasser dispergiert ist, umfasst, wobei die Glukose in der Wasserfilmlösung mit einer Menge von 1,5 bis 4,0 g/l enthalten ist und wobei das Bisfluorsulfonimidsalz Sodiumbisfluorsulfonimidsalz oder Lithiumbisfluorsulfonimidsalz ist und in dem Wasserlösungsfilm mit einer Menge von 0,1 bis 0,35 mol/l enthalten ist.

2. Verfahren, das die Wasserfilmlösung nach Anspruch 1 verwendet, **dadurch gekennzeichnet, dass** es die folgenden Schritte umfasst:
einen Schritt 1 des Verwendens der Wasserfilmlösung zum Bilden einer Schutzschicht auf einer Diffusionsvorderoberfläche eines Siliciumwafers; und
einen Schritt 2 des Einführens der hinteren Oberfläche und eines Randes des in Schritt 1 verarbeiteten Siliciumwafers in ein Ätzbad, um einen pn-Übergang zu ätzen, der sich auf der hinteren Oberfläche und dem Rand des Siliciumwafers befindet.

3. Verfahren, das die Wasserfilmlösung nach Anspruch 2 verwendet, wobei in dem Schritt 1 der Wasserfilm auf die Diffusionsvorderoberfläche durch eine Wasserfilmsprühbeschichtungstechnik aufgesprüht wird, um die Schutzschicht zu bilden.

4. Verfahren, das die Wasserfilmlösung nach Anspruch 2 verwendet, wobei in dem Schritt 2 in dem Ätzbad die hintere Oberfläche und der Rand des Siliciumwafers durch Schwimmen auf einer Ätzflüssigkeit geätzt werden.

5. Verfahren, das die Wasserfilmlösung nach Anspruch 2 verwendet, wobei in dem Schritt 2 in dem Ätzbad die hintere Oberfläche und der Rand des Siliciumwafers durch Verwenden einer Flüssigkeitswalze, um eine Ätzflüssigkeit zu der hinteren Oberfläche des Siliciumwafers zu bringen, geätzt werden.

## Revendications

1. Solution aqueuse pour film pour une utilisation pendant la gravure d'une tranche de silicium de cellule solaire, **caractérisée en ce que** la solution aqueuse pour film comprend du glucose et un sel de bisfluorosulfonimide dispersés dans l'eau, où le glucose est contenu dans la solution aqueuse pour film en une quantité allant de 1,5 à 4,0 g/L et où le sel de bisfluorosulfonimide est le bisfluorosulfonimide de sodium ou le bisfluorosulfonimide de lithium, et est contenu dans la solution aqueuse pour film en une quantité allant de 0,1 à 0,35 mol/L.

2. Procédé utilisant la solution aqueuse pour film selon la revendication 1, **caractérisé en ce qu'**il comprend les étapes suivantes :
une étape 1 consistant à utiliser la solution aqueuse pour film pour former une couche protectrice sur une surface avant de diffusion d'une tranche de silicium ; et
une étape 2 consistant à introduire la surface arrière et un bord de la tranche de silicium traitée à l'étape 1 dans un bain de gravure pour graver une jonction PN située sur la surface arrière et le bord de la tranche de silicium.

3. Procédé utilisant la solution aqueuse pour film selon la revendication 2, dans lequel, à l'étape 1, le film aqueux est pulvérisé sur la surface avant de diffusion par une technique de revêtement par pulvérisation de film aqueux pour former la couche protectrice.

4. Procédé utilisant la solution aqueuse pour film selon la revendication 2, dans lequel, à l'étape 2, dans le bain de gravure, la surface arrière et le bord de la tranche de silicium sont gravés en flottant sur un liquide de gravure.

5. Procédé utilisant la solution aqueuse pour film selon la revendication 2, dans lequel, à l'étape 2, dans le bain de gravure, la surface arrière et le bord de la tranche de silicium sont gravés en utilisant un rouleau à liquide pour amener un liquide de gravure à la surface arrière de la tranche de silicium.
